Europäisches Patentamt

European Patent Office

Office européen des brevets

(11) Numéro de publication : **0 359 777 B1**

## (12) FASCICULE DE BREVET EUROPEEN

(45) Date de publication du fascicule du brevet :
29.07.92 Bulletin 92/31

(21) Numéro de dépôt : **88905176.9**

(22) Date de dépôt : **31.05.88**

(86) Numéro de dépôt international :
**PCT/FR88/00272**

(87) Numéro de publication internationale :
**WO 88/09830 15.12.88 Gazette 88/27**

(51) Int. Cl.$^5$ : **C23F 4/00,** H01J 37/32,
H05H 1/46, C23C 16/50

### (54) PROCEDE DE GRAVURE PAR PLASMA GAZEUX.

(30) Priorité : **01.06.87 FR 8707631**

(43) Date de publication de la demande :
**28.03.90 Bulletin 90/13**

(45) Mention de la délivrance du brevet :
**29.07.92 Bulletin 92/31**

(84) Etats contractants désignés :
**DE FR GB IT NL**

(56) Documents cités :
**EP-A- 0 115 970**
**EP-A- 0 180 020**
**EP-A- 0 212 924**
**Journal of the Electrochemical Society,
vol.132, no.12, decembre 1985 (Manchester,
NH, US), S. Adachi et al. :"Reactive ionetching
of tungsten films sputter deposited on GaAs",
pages 2980-2989, voir pages 2983-2984, paragraphe "Effects of Ar, O2 and N2additions"**

(56) Documents cités :
**Microelectronic Engineering, vol. 3, no. 1/4,
decembre 1985, Elsevier Science Publishers
B.V. (Amsterdam, North-Holland, NL),J.
Paraszczak et al.:"Methods of creation and
effect of microwave plasmas upon the etching
of polymers and silicon", pages 397-410,voir
pages 400-401, figure 4d cité dans la
demande.**

(73) Titulaire : **COMMISSARIAT A L'ENERGIE
ATOMIQUE Etablissement de Caractère
Scientifique Technique et Industriel
31/33, rue de la Fédération
F-75015 Paris (FR)**

(72) Inventeur : **CHARLET, Barbara
11, rue des Lilas
F-38240 Meylan (FR)**
Inventeur : **PECCOUD, Louise
23, rue des Martyrs
F-38640 Claix (FR)**

(74) Mandataire : **Des Termes, Monique et al
Société Brevatome 25, rue de Ponthieu
F-75008 Paris (FR)**

## Description

La présente invention concerne un procédé de gravure par plasma utilisable pour la gravure de couches de nature quelconque (isolante, conductrice, semi-conductrice) sur des substrats quelconques (conducteurs, semi-conducteurs, isolants), en particulier pour la réalisation de structures de relief important dans le silicium.

L'invention s'applique particulièrement bien au domaine de la micro-électronique, notamment à la réalisation de têtes d'enregistrement magnétique et de circuits hydrides ainsi qu'aux domaines de l'optronique et des capteurs.

De façon connue, pour réaliser des gravures par plasma, on engendre ledit plasma en faisant réagir un milieu gazeux approprié avec des ondes hyperfréquences et/ou avec des ondes radiofréquences. L'interaction des ondes hyperfréquences ou radiofréquences avec te milieu gazeux permet en effet de dissocier le milieu gazeux en espèces ionisées (ions, électrons) et en espèces neutres (atomes, molécules) ; ces différentes espèces constituent le plasma et initient des réactions chimiques sur la couche à graver.

Ainsi, on connaît par le document J. Electrochem. Soc., vol. 132, décembre 1985 un procédé de gravure par un plasma engendré par des ondes radiofrèquences, utilisant comme milieu gazeux un gaz fluorant constitué par du $CF_4$ ou du $SF_6$ auquel on ajoute éventuellement de l'argon, de l'oxygène ou de l'azote. Dans ce document, il est montré que l'addition d'oxygène est néfaste sur la sélectivité de la gravure puisqu'elle augmente la vitesse de gravure du masque et diminue la vitesse de gravure du substrat, quel que soit le gaz fluorant utilisé. Aussi, on préconise d'utiliser comme milieu gazeux un système mixte $CF_4/N_2$ ou $SF_6/N_2$.

Un dispositif permettant de créer un plasma par des ondes hyperfréquences est par exemple décrit dans la demande de brevet français FR-A-2 534 040 et un dispositif permettant de créer un plasma par des ondes radiofréquences est par exemple décrit dans la demande de brevet FR-A-2 538 987.

On connaît par le brevet US-A-4298419 un procédé de gravure par plasma engendré par des ondes hyperfréquences dans lequel on utilise comme milieu gazeux un mélange de $C_2F_6$ et de $H_2$ et on applique une tension alternative dans le domaine des radiofréquences au substrat à graver pour obtenir une vitesse de gravure élevée lorsque le substrat est isolant ou recouvert d'isolant. Cependant, les vitesses de gravure obtenues avec ce procédé restent faibles puisqu'elles sont inférieures à 0,1 μm/min. Dans ce procédé, le plasma est engendré par couplage entre un guide d'onde et une colonne de gaz sans direction préférentielle et focalisé sur le substrat par création d'un champ magnétique. Pour des valeurs élevées de ce champ magnétique, on obtient la résonance cyclotronique des électrons qui accroît la dissociation du plasma. Ceci exige l'emploi de pressions relativement basses, inférieures à 6,5 Pa (50 mTorr) et de forts débits de pompage.

On connaît aussi par le brevet EP-A-0 180 020 et le document Microelectronic Engineering, vol. 3, n°1/4, 1985, p.397-410, des procédés de gravure par plasma utilisant simultanément des hyperfréquences et des radiofréquences avec un milieu gazeux qui est choisi parmi les halogènes, les gaz rares, etc. dans le cas du brevet EP-A-0 180 020 ou un mélange de $CF_4$ et d'oxygène dans le cas du document.

Ces procédés de gravure par plasma utilisant simultanément des hyperfréquences et des radiofréquences permettent généralement d'obtenir un résultat amélioré par rapport à celui que l'on obtient avec des plasmas engendrés uniquement par des radiofréquences.

Cependant, pour réaliser des structures profondes dans certains substrats, par exemple dans le silicium, d'une manière industrielle et avec une bonne définition par rapport à la géométrie déterminée par le masque, il est nécessaire d'améliorer encore les résultats, notamment la vitesse de gravure pour avoir une cadence industrielle importante, adaptée à la profondeur gravée et la maîtrise du profil gravé, soit l'anisotropie et la sélectivité de la gravure.

On rappelle que les caractéristiques d'une gravure effectuée dans une couche à l'aide d'un plasma sont la vitesse Vg, l'anisotropie A et la sélectivité S de la gravure. L'anisotropie d'une gravure A est déterminée par le rapport entre la largeur maximum de la gravure réalisée sous le matériau constituant le masque de la gravure et la profondeur de la gravure ; plus l'anisotropie A est faible, plus la gravure est anisotrope. La sélectivité S d'une gravure correspond au rapport entre la vitesse de gravure de la couche à graver et la vitesse de gravure du masque de la gravure. Plus la sélectivité S est grande, plus la sélectivité de la gravure est bonne.

La présente invention a justement pour objet un procédé de gravure qui permet d'obtenir des résultats améliorés, notamment en ce qui concerne la vitesse de gravure, la sélectivité et l'anisotropie, grâce au choix d'un milieu gazeux approprié.

Le procédé, selon l'invention, de gravure d'un substrat à l'aide d'un plasma gazeux engendré soit par des ondes hyperfréquences, soit par des ondes radiofréquences et des ondes hyperfréquences, se caractérise en ce que le milieu gazeux utilisé pour la formation du plasma comprend au moins un gaz fluorant non carboné, au moins un gaz rare, au moins un gaz oxydant non carboné et éventuellement au moins un autre gaz choisi parmi l'azote et les gaz chlorés, par exemple le chlore.

Grâce au choix d'un tel milieu gazeux, on obtient non seulement un plasma fortement dissocié, mais de

2

plus un plasma très riche en espèces réactives. Par ailleurs, en réglant la composition de ce milieu, on peut adapter ses capacités aux exigences de la gravure profonde.

Dans ce milieu, le gaz fluorant non carboné susceptible d'être utilisé peut être par exemple l'hexafluorure de soufre $SF_6$. On peut aussi utiliser le trifluorure d'azote $NF_3$. En effet, l'utilisation de ces gaz fluorés permet de former un plasma fortement dissocié et très riche en espèces réactives.

$NF_3$ peut remplacer en partie ou complètement l'hexafluorure de soufre car il joue le même rôle que celui-ci en tant que gaz réactif fournisseur de fluor pour la gravure et l'azote résultant de la décomposition de $NF_3$ est compatible avec le procédé de gravure.

Les gaz rares susceptibles d'être utilisés peuvent être par exemple l'hélium, l'argon, le néon et le krypton. Le gaz rare ou le mélange de gaz rares utilisé assure la stabilité de la décharge et son extension jusqu'au substrat.

En effet, la dissociation d'un gaz rare conduit à des espèces ionisées et neutres à durée de vie importante, ce qui permet de maintenir ainsi un certain temps les décharges provoquées par les ondes hyperfréquences associées éventuellement à des ondes radiofréquences. Généralement, on utilise l'argon ou un mélange d'argon et d'hélium.

En effet, l'hélium qui assure comme l'argon la stabilité du plasma réactif en ce qui concerne la propagation du plasma et le transfert de l'énergie aux espèces réactives, diminue la température du substrat par rapport à celle obtenue dans un plasma d'argon seul en assurant un meilleur transfert de calories dans le milieu. En effet, la conductivité thermique de l'hélium à des températures supérieures à 100°C est beaucoup plus grande que celle de l'argon.

Le gaz oxydant susceptible d'être utilisé est en particulier l'oxygène qui stimule la formation de produits volatils après la décomposition du gaz fluorant et après la réaction de ses radicaux avec la surface du substrat à graver. On peut utiliser d'autres gaz oxydants non carbonés, par exemple du $N_2O$ qui se décomposera en azote et oxygène, l'azote étant compatible avec le procédé de gravure.

Un mélange gazeux comprenant uniquement un gaz fluorant non carboné tel que $SF_6$, un gaz rare tel que l'argon et un gaz oxydant tel sue l'oxygène permet d'obtenir une grande réactivité de la décharge même lorsque celle-ci est produite uniquement par des hyperfréquences. Ainsi, lorsqu'on utilise ce procédé pour la gravure du silicium, on peut obtenir :
- une vitesse de gravure du silicium d'au moins 10μm/min,
- une sélectivité par rapport au masque en $SiO_2$ très élevée, supérieure à 100,
- une uniformité de profondeur gravée supérieure à 95%.

Par ailleurs, la vitesse de gravure est indépendante de l'orientation cristalline du silicium Si<100> ou <111>, ainsi que du type de dopage et de la dose de dopant du silicium et l'on peut traverser un substrat ayant une épaisseur supérieure à 500μm. On obtient de plus un profil de gravure isotrope ou contrôlable d'angle alpha compris entre 50 et 70°, un état de surface à très faible rugosité pour des profondeurs importantes de gravure et une surface de silicium et du masque en $SiO_2$ sans dépôt de polymères parasites.

Lorsqu'on utilise ce même mélange gazeux avec un plasma d'excitation mixte à hyperfréquence et radiofréquence sur un substrat en silicium, on obtient les performances suivantes :
- la vitesse de gravure est sensiblement la même, environ 8μm/min,
- la sélectivité par rapport au masque en $SiO_2$ est d'environ 80,
- l'uniformité de la profondeur gravée est de 95%.

De même, la vitesse de gravure est indépendante de l'orientation cristalline du silicium, du type de dopage et de la dose de dopant. On peut traverser un substrat d'épaisseur supérieure à 500μm. On obtient un profil de gravure d'angle alpha contrôlable compris entre 60 et 90°, dont un gain en profil par rapport au plasma hyperfréquence. L'état de surface a une très faible rugosité, inférieure à 0,1μm et il n'y a pas de dépôt de polymères parasites sur la surface du silicium et du masque.

Ces résultats sont dus au choix d'un milieu gazeux comprenant simultanément un gaz fluorant, un gaz oxydant et un gaz rare. En effet, si l'on utilisait pour la gravure un plasma obtenu à partir d'un seul de ces gaz, on n'obtiendrait pas tous les avantages mentionnés ci-dessus tels que la vitesse de gravure, la sélectivité, l'uniformité et la qualité de surface.

Selon une variante de réalisation de l'invention, qui peut être mise en oeuvre pour la gravure d'un substrat par un plasma gazeux engendré soit par des hyperfréquences, soit par des hyperfréquences et des radiofréquences, le mélange gazeux formé du ou des gaz fluorants non carbonés, du ou des gaz rares et du ou des gaz oxydants non carbonés comprend en outre un autre gaz pour influencer les résultats de gravure.

Ce gaz peut être l'azote qui permet d'améliorer l'état de surface de la couche gravée provoquant une diminution de 30% de la rugosité et améliorant l'homogénéité de gravure d'environ 10%. L'effet de l'azote peut être attribué à son rôle dans la décharge en tant que producteur d'espèces de longue durée de vie et de faible énergie qui permettent une plus grande efficacité et une plus grande homogénéité d'évacuation des produits réactifs.

Le gaz ajouté peut être un gaz chloré tel que le chlore, ce qui permet d'améliorer le profil des motifs gravés, notamment dans le cas où le plasma est engendré uniquement par des hyperfréquences , l'angle alpha passant de 60 à 80° au lieu de 50 à 70°. L'intervention du chlore sur l'angle alpha du profil de gravure peut s'expliquer par la formation de produits intermédiaires non volatils du type $SiCl_x$ avec $x \leq 3$, par les étapes d'absorption du chlore à la surface du silicium, puis par la formation d'un produit relativement stable. Ce processus se développe en particulier sur les parois des motifs gravés qui reçoivent moins de bombardement ionique direct provenant du plasma par rapport au fond de la gravure. Dans le cas où la gravure est effectuée avec un plasma engendré par des hyperfréquences et des radiofréquences, les phénomènes de bombardement ionique sont amplifiés par l'existence d'une gaine au niveau du substrat qui favorise le bombardement perpendiculairement au fond de la gravure. Par ce biais, on obtient des profils gravés voisins de 90°.

Lorsque, selon l'invention, on réalise la gravure d'un substrat au moyen d'un plasma gazeux engendré par des hyperfréquences et des radiofréquenses, on confine sur le substrat par une cellule en matériau transparent aux ondes hyperfréquences un plasma gazeux engendré par couplage monomode transversal entre un guide d'onde parcouru par des ondes hyperfréquences et la cellule dans laquelle au moins une partie du milieu gazeux de gravure circule perpendiculairement aux ondes hyperfréquences pour être dirigé sur le substrat, et on applique simultanément au substrat une tension électrique continue ou une tension électrique alternative ayant une fréquence dans le domaine des radiofréquences.

Ce procédé de gravure par plasma utilisant simultanément les hyperfréquences et les radiofréquences permet d'obtenir une grande efficacité de dissociation des gaz au voisinage du substrat à graver car l'efficacité de dissociation est directement reliée à la densité électronique du plasma qui est généralement environ 100 fois plus grande dans ce cas que dans une décharge induite dans le même gaz par un dispositif radiofréquence.

Toutefois, le procédé de l'invention permet aussi l'obtention de bons résultats avec un plasma gazeux engendré uniquement par des hyperfréquences. Dans ce cas, on confine sur le substrat par une cellule en matériau transparent aux ondes hyperfréquences un plasma gazeux engendré par couplage monotransversal entre un guide d'ondes parcouru par des ondes hyperfréquences et la cellule dans laquelle au moins une partie du milieu gazeux de gravure circule perpendiculairement aux ondes hyperfréquences pour être dirigé sur le substrat.

Dans les deux cas, on réalise la gravure sous une pression allant de 0,1 à 300 Pa, de préférence de 1 à 100 Pa.

Dans les deux cas, lorsque le milieu gazeux est formé de trois gaz tels que $SF_6$, Ar et $O_2$, les débits respectifs de ces trois gaz sont situés dans les gammes suivantes :
- 4-500 cm³ standard/min pour $SF_6$,
- 4-500 cm³ standard/min pour Ar,
- 2-500 cm³ standard/min pour $O_2$,

soit des pressions de :
- 0,27 à 67,5 Pa,
- 0,27 à 135 Pa,
- 0,13 à 67,5 Pa,

ce qui correspond à une pression totale allant de 0,67 à 270 Pa.

Lorsque le milieu gazeux est formé de quatre gaz tels que $SF_6$, Ar, $O_2$ et $N_2$, les débits respectifs de ces gaz sont situés dans les gammes suivantes :
- 4-500 cm³ standard/min pour $SF_6$,
- 4-500 cm³ standard/min pour Ar,
- 1-300 cm³ standard/min pour $O_2$,
- 1-300 cm³ standard/min pour $N_2$,

soit des pressions de :
- 0,27 à 67,5 Pa pour $SF_6$,
- 0,27 à 135 Pa pour Ar,
- 0,13 à 67,5 Pa pour $O_2$, et
- 0,13 à 67,5 Pa pour $N_2$.

Ceci correspond à des pressions totales allant de 0,53 à 270 Pa.

On précise que dans l'invention, on entend par substrat, aussi bien un seul matériau qu'une superposition de couches de matériaux différents, la gravure étant dans ce cas effectuée sur la dernière couche protégée ou non par un masque.

De préférence, la cellule en matériau transparent aux ondes hyperfréquences débouche au-dessus du substrat par une partie évasée.

Ainsi, lorsqu'on utilise un plasma gazeux engendré par des hyperfréquences et des radiofréquences, on peut obtenir des vitesses de gravure élevées, notamment lorsque le substrat ou la surface supérieure de celui-ci est en matériau conducteur ou semi-conducteur, par exemple en silicium polycristallin.

Ceci provient en particulier du mode de création et de confinement du plasma. En effet, le fait d'utiliser un plasma propagatif dirigé sur le substrat par une cellule en matériau transparent aux rayonnements électromagnétiques qui débouche sur le substrat par une partie évasée, permet de confiner le plasma sur le substrat et d'opérer à des pressionss supérieures à celles utilisées dans le brevet américain US-A-4298419. En opérant à des pressions plus élevées, on peut obtenir des débits de gaz supérieurs, par exemple de l'ordre de 100 $Cm^3$ standard/min et créer ainsi plus d'espèces réactives, ce qui permet d'augmenter la vitesse de gravure d'un facteur de 10. Ainsi, avec le procédé de l'invention, en opérant sous une pression de 13,5 Pa, on peut atteindre une vitesse de gravure du silicium d'au moins 15μm/min alors que le procédé du brevet US-A-4298419 ne conduit qu'à des vitesses de gravure du silicium d'environ 0,015 μm/min.

Dans le procédé de l'invention, grâce au mode de propagation du plasma micro-onde, et au mode de couplage entre le plasma et l'onde hyperfréquence, l'application d'une tension électrique alternative ou continue sur le substrat permet d'améliorer le profil de la gravure.

L'application d'une tension alternative au substrat crée au voisinage de celui-ci une gaine qui s'oppose à l'arrivée des espèces réactives du plasma micro-onde et abaisse de ce fait la sélectivité et la vitesse de gravure d'un matériau semiconducteur tel que le silicium, en augmentant l'anisotropie du profil de gravure.

Dans le procédé du brevet américain, lorsque le substrat est en matériau isolant, ou comporte une couche de surface isolante, par exemple en $SiO_2$, on obtient une vitesse de gravure plus élevée que dans le cas du silicium, alors que l'on obtient un phénomène inverse avec le procédé de l'invention, lorsque l'on opère à une pression d'environ 10 Pa, puisque dans ce cas, la vitesse de gravure de l'oxyde de silicium est plus faible que celle du silicium.

Dans le procédé de l'invention, les ondes hyperfréquences sont couplées avec le plasma à l'intérieur de la cellule en matériau transparent aux ondes hyperfréquences. Il se crée ainsi un équilibre entre le plasma qui possède ses propres caractéristiques énergétiques et les ondes hyperfréquences. Celles-ci sont transmises directement au plasma par l'intermédiaire du guide d'onde et de la cellule. Par ailleurs, il n'est pas nécessaire d'utiliser un champ magnétique pour ioniser fortement le milieu gazeux.

Dans le procédé du brevet américain, les ondes hyperfréquences engendrent le milieu excité à l'extrémité de leurs lignes de propagation qui se situe sur la chambre de décharge et la présence du champ magnétique permet de confiner les espèces dissociées sur le substrat afin d'éviter leur recombinaison sur les parois de la chambre de décharge.

Ainsi, avec le procédé de l'invention, on peut obtenir une meilleure sélectivité de gravure du silicium par rapport à un masque en $SiO_2$, et pour l'obtention d'un profil donné, on peut avoir une meilleure vitesse de gravure (au moins 10μ m/min) et une meilleure sélectivité, généralement supérieure à 100 lorsqu'on opère sous 10 Pa.

Le procédé de l'invention permet de graver par exemple des matériaux isolants tels que des matériaux organiques (polyimides, résines...), des matériaux semi-conducteurs tels que le silicium polycristallin, monocristallin ou amorphe, les composés III-V et des matériaux conducteurs tels que le tungstène, le molybdène, le tantale, le niobium, le titane et leurs siliciures.

Le procédé de l'invention permet de réaliser un compromis entre la sélectivité S, la vitesse Vg et l'anisotropie A de la gravure obtenue avec des plasmas engendrés soit par des ondes hyperfréquences soit par des ondes radiofréquences. Le procédé de l'invention permet en effet d'améliorer la vitesse Vg et la sélectivité S d'un procédé de gravure par plasma engendré par des ondes radiofréquences tout en conservant une bonne anisotropie A de la gravure. De ce fait, le procédé de l'invention est particulièrement intéressant pour réaliser des gravures profondes comme par exemple pour la mise en oeuvre de têtes d'enregistrement magnétiques.

Pour mettre en oeuvre le procédé de l'invention avec un plasma engendré par des ondes hyperfréquences et radiofréquences, les ondes hyperfréquences et les ondes radiofréquences sont établies indépendamment les unes des autres. Les ondes radiofréquences amorcent la création du plasma et permettent ainsi aux ondes hyperfréquences de se coupler au plasma pour contribuer également à la création de ce plasma.

Pour qu'il n'y ait pas d'interaction parasite entre les ondes hyperfréquences et les ondes radiofréquences, l'interaction des ondes hyperfréquences avec le milieu gazeux se fait à distance de l'interaction des ondes radiofréquences avec le milieu gazeux. Cette distance est par exemple choisie de l'ordre de 7 cm. La distance établie entre ces deux types d'interaction permet de ne pas perturber la propagation des ondes hyperfréquences et radiofréquences et d'assurer une bonne superposition de celles-ci dans le milieu gazeux.

La fréquence des ondes hyperfréquences est par exemple comprise entre 0,2 GHz et 9 GHz et celle des ondes radiofréquences est comprise entre 0,02 MHz et 15 MHz.

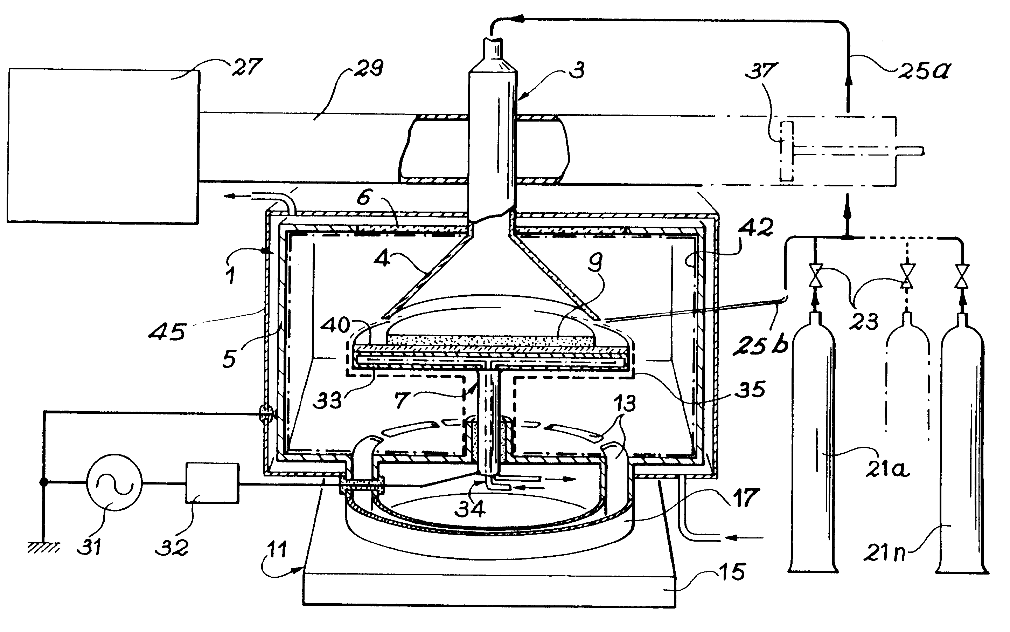

D'autres caractéristiques et avantages de l'invention ressortiront mieux de la description qui va suivre, donnée à titre purement illustratif et non limitatif, en référence à la figure annexée représentant un exemple de réalisation d'un dispositif permettant la mise en oeuvre du procédé de l'invention.

Sur cette figure est représentée une enceinte 1 constituée par une cellule 3 en un matériau transparent aux ondes hyperfréquences et une cavité 5 en un matériau conducteur, transparent ou non aux ondes hyperfréquences. Lorsque la cavité 5 est en matériau conducteur, la partie 6 de cette cavité au voisinage de la cellule 3 est en matériau isolant, par exemple en quartz. La partie inférieure 4 de la cellule débouche dans la partie supérieure de la cavité par une partie évasée. La cellule est constituée par exemple par du quartz tandis que la cavité est par exemple en aluminium ou en acier inoxydable.

A l'intérieur de la cavité est disposé un support 7 apte à recevoir un ou plusieurs substrats à graver. Pour plus de simplicité, on a représenté sur le support un seul substrat 9 constitué d'un seul matériau correspondant à la couche à graver. La partie évasée 4 de la cellule est en regard du substrat 9, l'ouverture de cette partie ayant des dimensions fonction de celles du substrat 9.

Ce dispositif comprend des moyens pour introduire un milieu gazeux dans l'enceinte. Ces moyens comprennent plusieurs réservoirs de gaz 21a,... 21n comprenant différents gaz, reliés par l'intermédiaire de vannes de réglage de débit 23 et par une canalisation 25a à la partie supérieure de la cellule 3. On peut aussi avoir différentes canalisations pour introduire séparément les gaz en des endroits différents de la cellule, par exemple introduire le gaz réactif fluoré au niveau du substrat par la conduite 25b et introduire le gaz rare et $O_2$ à la partie supérieure de la cellule 3.

Le dispositif comprend aussi des moyens 11 de pompage qui peuvent permettre d'établir le vide dans l'enceinte et de réaliser la circulation ou non du milieu gazeux introduit dans l'enceinte et l'extraction du milieu gazeux résultant des réactions chimiques établies dans l'enceinte. Ces moyens 11 sont reliés à la partie inférieure de la cavité 5 par une fente annulaire discontinue 13 située dans la paroi inférieure de celle-ci et centrée sur le support 7. Ces moyens de pompage comprennent par exemple une pompe 15 reliée de façon étanche par une canalisation torique 17 à la fente située dans la cavité.

Le dispositif représenté sur cette figure comprend par ailleurs des moyens pour engendrer des ondes hyperfréquences dans l'enceinte 1. Ces moyens comprennent un générateur d'ondes hyperfréquences 27 relié par un guide d'ondes 29 de section rectangulaire à la cellule de section circulaire. Ainsi, les parois associées aux grands côtés du guide d'onde comportent une ouverture circulaire permettant le passage de la cellule cylindrique au travers du guide d'ondes.

Les dimensions de la section transversale du guide d'ondes sont choisies en fonction des fréquences des ondes hyperfréquences utilisées. A une des extrémités du guide d'ondes opposée au générateur d'ondes hyperfréquences est installé un piston 37 solidaire d'une tige permettant de faire coulisser manuellement ou automatiquement le piston sur une certaine longueur. Cette longueur est de préférence de l'ordre de grandeur de la longueur d'onde du mode de propagation du guide d'ondes. Ce piston permet de régler la longueur du guide d'ondes afin de permettre, comme on l'a vu précédemment, une absorption maximum et constante de la puissance des ondes hyperfréquences transmises au milieu gazeux par le guide d'ondes. Un exemple de couplage d'un guide d'ondes avec une cellule de gaz utilisable dans le dispositif conforme à l'invention est par exemple décrit dans les brevets FR-A-2 534 040, 2 290 126 et 2 346 939 et US-A-4 049 940.

Le dispositif comprend en outre des moyens pour engendrer des ondes radiofréquences dans l'enceinte. Ces moyens comprennent un générateur d'ondes radiofréquences 31 relié d'une part à une électrode radiofréquence 33 et d'autre part à une contre-électrode reliée à la masse. L'électrode 33 est constituée par une partie du support 7. En effet, ce support 7 comprend l'électrode 33 et un plateau 40 en un matériau isolant tel que le quartz situé sur l'électrode 33. Ce plateau permet en surélevant le substrat 9 de diminuer les phénomènes de gaine. Les ondes radiofréquences interagissent avec le milieu gazeux de l'enceinte, au voisinage du support.

La contre-électrode est également constituée par les parois conductrices de la cavité étant bien entendu qu'elle peut être également constituée par une électrode supplémentaire 35 (représentée en traits pointillés) située autour de l'électrode 33 et au voisinage de celle-ci ou encore par les parois de la cavité et l'électrode supplémentaire. Dans le cas de l'utilisation d'une électrode supplémentaire, celle-ci est par exemple comme représenté sur cette figure reliée directement aux parois conductrices de la cavité connectées à la masse et située à une faible distance de l'électrode 33.

Pour régler la puissance des ondes radiofréquences afin d'obtenir une absorption maximum et constante de la puissance de ces ondes dans le milieu gazeux, on utilise comme on l'a vu précédemment une boite d'accord 32 reliée entre le générateur d'onde radiofréquence 31 et l'électrode radiofréquence 33.

Par ailleurs, un circuit de refroidissement 34 assure la circulation d'un liquide de refroidissement à l'intérieur de cette électrode 33 pour permettre le refroidissement du substrat 9.

Ce dispositif peut comprendre également des moyens (non représentés) pour régler en hauteur la position du support 7 et donc du substrat 9 par rapport au plasma créé par les ondes hyperfréquences dans la cellule et par rapport à l'ouverture de la partie évasée de la cellule de façon à ce que l'interaction des ondes hyperfréquences avec le milieu gazeux et que l'interaction des ondes radiofréquences avec le milieu gazeux ne perturbe pas la propagation de ces deux types de plasma.

Des moyens d'étanchéité sont par ailleurs prévus entre la cellule et le réacteur, entre le réacteur et les moyens de pompage et entre l'électrode radiofréquence et le réacteur.

La cavité du réacteur étant réalisée en un matériau conducteur, celle-ci est recouverte de façon avantageuse par chauffage ou par projection au chalumeau à plasma, d'un revêtement 42 n'interagissant pas avec le plasma, sur toute sa paroi intérieure. Le matériau de revêtement est par exemple de l'alumine ($Al_2O_3$) d'une épaisseur comprise entre $300\mu m$ et $50\mu m$. Ce type de traitement pour passiver les parois de la cavité, vis-à-vis du plasma créé dans la cavité, est par exemple décrit dans la demande de brevet FR-A-2 538 987.

De nombreuses modifications peuvent être bien entendu effectuées sur le dispositif représenté sur cette figure. Ainsi, par exemple, comme décrit dans la demande de brevet FR-A-2 534 040, dans certains cas, on ajoute avantageusement dans le guide d'onde au voisinage de la cellule, des coins métalliques.

Ce dispositif permet donc de graver un substrat à l'aide d'un plasma engendré par interaction d'un milieu gazeux approprié avec des ondes hyperfréquences et des ondes radiofréquences. Ce milieu gazeux peut être en circulation ou non dans l'enceinte suivant le cas par l'intermédiaire des moyens de pompage.

Il peut aussi être utilisé pour la gravure d'un substrat par un plasma gazeux engendré uniquement par des ondes hyperfréquences en supprimant le générateur 31, etc.

Pour graver une couche de silicium à travers un masque de dioxyde de silicium, on introduit tout d'abord la couche de silicium recouverte par son masque sur le support 7, on établit la pression dans l'enceinte par les moyens de pompage à une pression voulue et on introduit dans la cellule par l'intermédiaire de la canalisation 25, des vannes 23 et des différentes bouteilles 21a,... 21n les gaz tels que $SF_6$, l'argon, l'oxygène et éventuellement azote aux débits voulus. On fait interagir ensuite le milieu gazeux ainsi créé avec des ondes hyperfréquences engendrées par le générateur 27 d'ondes hyperfréquences et introduites dans la cellule par le guide d'ondes 29 et éventuellement avec des ondes radiofréquences au voisinage de l'électrode radiofréquence 33.

Les exemples suivants, concernant la gravure de silicium polycristallin, sont donnés bien entendu à titre non limitatif pour illustrer l'invention.

EXEMPLE 1

Dans cet exemple, on utilise un milieu gazeux formé d'hexafluorure de soufre, d'oxygène et d'argon pour la gravure par un plasma engendrée simultanément par des radiofréquences et des hyperfréquences ayant des puissances respectives de 200W et 800W. On fait circuler dans l'enceinte l'hexafluorure de soufre à un débit de 15 cm³ standard/min, argon à un débit de 15 cm³ standard/min, et l'oxygène un débit de 5 cm³ standard/min sous une pression de l'ordre de 1Pa et à une température de 80°C. Dans ces conditions, on obtient les résultats suivants :
  – vitesse de gravure Vg : $8\mu m/min$,
  – sélectivité S : 10,
  – anisotropie A : $\leqq 0,05$.

EXEMPLE 2

Dans cet exemple, on utilise le même milieu gazeux que dans l'exemple 1 et on le fait circuler dans l'enceinte avec les mêmes débits mais l'on forme le plasma uniquement par des ondes hyperfréquences ayant une puissance de 800W. Dans ce cas, on obtient les résultats suivants :
  – vitesse de gravure Vg : $15\mu m/min$,
  – sélectivité S : 64,
  – anisotropie A : 0,52.

EXEMPLE 3

Dans cet exemple, on suit le même mode opératoire que dans l'exemple 1, sauf que les débits respectifs de $SF_6$, $O_2$ et Ar sont ceux donnés dans le tableau qui suit.

On obtient les résultats donnés dans le tableau qui suit.

Exemple comparatif 1

On utilise le même mode opératoire que dans l'exemple 3 pour graver du silicium mais en utilisant comme mélange gazeux un mélange de $CF_4$, d'$O_2$ et d'Ar introduits dans l'enceinte aux débits suivants :
- 50 $cm^3$ standard/min pour $CF_4$,
- 10 $cm^3$ standard/min pour $O_2$,
- 30 $cm^3$ standard/min pour Ar.

Les résultats obtenus sont donnés également dans le tableau qui suit.

Au vu de ces résultats, on constate que le remplacement du $SF_6$ par $CF_4$ conduit à l'obtention de résultats bien inférieurs. On suppose que, dans ce cas, la formation d'un produit stable non volatil à la surface du silicium du type CF ralentit la réaction du silicium avec le fluor de la décharge et conduit à des résultats nettement moins bons.

EXEMPLE 4

Dans cet exemple, on suit le même mode opératoire que dans l'exemple 1, mais on utilise un mélange gazeux comprenant $SF_6$, Ar, $O_2$ et $N_2$. Les débits respectifs des gaz sont les suivant :
- 50 $cm^3$ S/min pour $SF_6$, soit une pression partielle de 1,62 Pa (12 mTorr),
- 30 $cm^3$ S/min pour Ar, soit une pression partielle de 0,81 Pa (6 mTorr),
- 10 $cm^3$ S/min pour $O_2$ , soit une pression partielle de 0,27 Pa (2 mTorr),
- 10 $cm^3$ S/min pour $N_2$, soit une pression partielle de 0,27 Pa (2 mTorr).

Dans ces conditions, on obtient les résultats suivants :
- vitesse de gravure du Si : 6$\mu$m/min,
- vitesse de gravure du masque en $SiO_2$ : 0,03/$\mu$m/min,
- sélectivité : S=200,
- angle alpha : 70°.

EXEMPLE 5

On suit le même mode opératoire que dans l'exemple 4 avec les débits suivants :
- 50 $cm^3$ standard/min (1,5 Pa) pour $SF_6$,
- 32 $cm^3$ standard/min (1 Pa) pour Ar,
- 8 $cm^3$ standard/min (0,35 Pa) pour $O_2$,
- 8 $cm^3$ standard/min (0,35 Pa) pour $N_2$,

On obtient des résultats équivalents à ceux de l'exemple 4.

## T A B L E A U

| | EXEMPLE 2 | EXEMPLE COMPARATIF 1 |
|---|---|---|
| débit de $SF_6$ | 50 cm$^3$ S/min | |
| débit de $CF_4$ | | 50 cm$^3$ S/min |
| débit d'$O_2$ | 10 " | 10 " |
| débit d'Ar | 30 " | 30 " |
| Vitesse de gravure de Si | 4,2 $\mu$m/min | 0,35 $\mu$m/min |
| Vitesse de gravure de $SiO_2$ | 0,01 $\mu$m/min | 0,14 $\mu$m/min |
| Sélectivité S | 420 | 2,5 |
| Homogénéité | Si$\pm$1,5% ; $SiO_2\pm$1,5% | Si$\pm$4% ; $SiO_2\pm$11% |
| Anisotropie A | 0,8 | 0,5 |
| Rugosité de surface | <80 nm | < 50 nm |

L'exemple de réalisation d'un dispositif pour la mise en oeuvre du procédé de l'invention représenté sur la figure annexée est donné à titre illustratif et non limitatif.

En effet, le procédé de l'invention peut être mis en oeuvre dans tous les dispositifs de gravure à l'aide d'un plasma engendré par des ondes hyperfréquences utilisant le mode de couplage guide d'onde-cellule de gaz (surfaguide) décrit ci-dessus, à condition bien entendu d'utiliser un support apte à supporter ladite couche qui soit au moins en partie conducteur et éventuellement un générateur d'ondes radiofréquences qui soit relié d'une part à la partie conductrice du support et d'autre part à une contre-électrode reliée à la masse ou inversement, la couche sur l'électrode étant reliée à la nasse et la contre électrode au générateur de radio fréquences. Cette contre-électrode est constituée soit par une électrode supplémentaire disposée dans l'enceinte par exemple autour du support, soit par au moins une partie de l'enceinte, soit encore par au moins une partie de l'enceinte et une électrode supplémentaire.

Dans certains cas, il est préférable de refroidir les parois de l'enceinte constituant le réacteur. Aussi, le dispositif comprend des moyens de refroidissement appropriés, par exemple une circulation d'eau entre la paroi de la cavité 5 et une paroi supplémentaire 45, pour maintenir par exemple la paroi 5 à la température ambiante.

**Revendications**

1. Procédé de gravure d'un substrat à l'aide d'un plasma gazeux engendré soit par des ondes hyperfréquences, soit par des ondes radiofréquences et des ondes hyperfréquences, caractérisé en ce que le milieu gazeux utilisé pour la formation du plasma comprend au moins un gaz fluorant non carboné, au moins un gaz rare et au moins un gaz oxydant non carboné.

2. Procédé selon la revendication 1, caractérisé en ce que le milieu gazeux comprend en outre au moins un autre gaz choisi parmi l'azote et les gaz chlorés.

3. Procédé selon l'une quelconque des revendications 1 et 2, caractérisé en ce que le gaz fluorant non carboné est l'hexafluorure de soufre $SF_6$.

4. Procédé selon l'une quelconque des revendications 1 à 3, caractérisé en ce que le gaz rare est l'argon ou un mélange d'argon et d'hélium.

5. Procédé selon l'une quelconque des revendications 1 à 4, caracterisé en ce que le gaz oxydant est l'oxygène.

6. Procédé selon la revendication 1, caractérisé en ce que le milieu gazeux est constitué d'hexafluorure de soufre, d'argon et d'oxygène.

7. Procédé selon la revendication 6, caractérisé en ce que les débits respectifs d'hexafluorure de soufre, d'argon et d'oxygène sont situés dans les gammes suivantes :
- 4 à 500 cm$^3$ standard/min pour $SF_6$,
- 4 à 500 cm$^3$ standard/min pour Ar, et
- 2 à 500 cm$^3$ standard/min pour $O_2$.

8. Procédé selon la revendication , caractérisé en ce que le milieu gazeux est constitué d'hexafluorure de soufre, d'argon, d'oxygène et d'azote.

9. Procédé selon la revendication 8, caractérisé en ce que les débits respectifs d'hexafluorure de soufre, d'argon, d'oxygène et d'azote sont situés dans les gammes suivantes :
- 4 à 500 cm$^3$ standard/min pour $SF_6$,
- 4 à 500 cm$^3$ standard/min pour Ar,
- 1 à 300 cm$^3$ standard/min pour $O_2$, et
- 1 à 300 cm$^3$ standard/min pour $N_2$.

10. Procédé selon l'ne quelconque des revendications 1 à 9, caractérisé en ce que le substrat est en silicium.

11. Procédé selon l'une quelconque des revendications 1 à 10, caractérisé en ce que l'on réalise la gravure sous une pression allant de 0,1 à 300 Pa.

12. Procédé selon l'une quelconque des revendications 1 à 11, caractérisé en ce que l'on réalise la gravure au moyen d'un plasma gazeux engendré par des ondes hyperfréquences et des ondes radiofrèquences en confinant sur le substrat par une cellule en matériau transparent aux ondes hyperfréquences un plasma gazeux engendré par couplage monomode transversal entre un guide d'ondes parcouru par des ondes hyperfréquences et la cellule dans laquelle au moins une partie du milieu gazeux de gravure circule perpendiculairement aux ondes hyperfréquences pour être dirigée sur le substrat, et en appliquant simultanément au substrat une tension électrique continue ou une tension électrique alternative ayant une fréquence dans le domaine des radiofréquences.

13. Procédé selon l'une quelconque des revendications 1 à 11, caractérisé en ce que l'on réalise la gravure au moyen d'un plasma gazeux engendré par des ondes hyperfréquences en confinant sur le substrat par une cellule en matériau transparent aux ondes hyperfréquences un plasma gazeux engendré par couplage monomode transversal entre un guide d'ondes parcouru par des ondes hyperfréquences et la cellule dans laquelle au moins une partie du milieu gazeux de gravure circule perpendiculairement aux ondes hyperfréquences pour être dirigée sur le substrat.


**Patentansprüche**

1. Verfahren zum Ätzen eines Substrats mittels eines Gasplasmas, das entweder durch hochfrequente Wellen, durch Radiofrequenzwellen oder durch Höchstfrequenzwellen erzeugt wird, dadurch gekennzeichnet, daß die gasförmige Umgebung zum Erzeugen des Plasmas wenigstens ein fluorierendes, nicht kohlenstoffhaltiges Gas, wenigsten ein Edelgas und wenigstens ein oxydierendes, nicht kohlenstoffhaltiges Gas umfaßt.

2. Verfahren nach Anspruch 1, dadurch gekennzeichnet, daß die gasförmige Umgebung wenigstens ein weiteres Gas umfaßt, das unter dem Stickstoff und den chlorierten Gasen ausgewählt wird.

3. Verfahren nach einem der Ansprüche 1 und 2, dadurch gekennzeichnet, daß das fluorierende, nicht kohlenstoffhaltige Gas das Hexafluorid des Schwefels $SF_6$ ist.

4. Verfahren nach einem der Ansprüche 1 bis 3, dadurch gekennzeichnet, daß das Edelgas Argon oder eine Mischung aus Argon und Helium ist.

5. Verfahren nach einem der Ansprüche 1 bis 4, dadurch gekennzeichnet, daß das oxydierende Gas Sauerstoff ist.

6. Verfahren nach Anspruch 1, dadurch gekennzeichnet, daß die gasförmige Umgebung aus Schwefelhexafluorid, Argon und Sauerstoff besteht.

7. Verfahren nach Anspruch 6, dadurch gekennzeichnet, daß der jeweilige Verbrauch von Schwefelhexafluorid, Argon und Sauerstoff in den folgenden Spannen liegt:
– 4 bis 500 Standard-cm³/min für $SF_6$,
– 4 bis 500 Standard-cm³/min für Ar, und
– 2 bis 500 Standard-cm³/min für $O_2$.

8. Verfahren nach Anspruch 1, dadurch gekennzeichnet, daß die gasförmige Umgebung aus Schwefelhexafluorid, Argon, Sauerstoff und Stickstoff besteht.

9. Verfahren nach Anspruch 8, dadurch gekennzeichnet, daß der jeweilige Verbrauch von Schwefelhexafluorid, Argon, Sauerstoff und Stickstoff in den folgenden spannen liegt:
– 4 bis 500 Standard-cm³/min für $SF_6$,
– 4 bis 500 Standard-cm³/min für Ar,
– 1 bis 300 Standard-cm³/min für $O_2$, und
– 1 bis 300 Standard-cm³/min für $N_2$.

10. Verfahren nach einem der Ansprüche 1 bis 9, dadurch gekennzeichnet, daß das Substrat Silizium ist.

11. Verfahren nach einem der Ansprüche 1 bis 10, dadurch gekennzeichnet, daß man die Ätzung unter einem Druck von 0,1 bis 300 Pa durchführt.

12. Verfahren nach einem der Ansprüche 1 bis 11, dadurch gekennzeichnet, daß man die Atzung mittels eines gasförmigen Plasmas durchführt, das durch Höchstfrequenzwellen und Radiofrequenzwellen erzeugt wird, indem auf das Substrat mittels einer Zelle aus einem für die Höchstfrequenzwellen transparentem Material ein gasförmiges Plasma beschränkt, das durch eine transversale, einmodige Kopplung zwischen einem Wellenleiter, der von Höchstfrequenzwellen durchlaufen wird, und der Zelle, in der wenigstens ein Teil der gasförmigen Umgebung senkrecht zu den Höchstfrequenzwellen zirkuliert, um auf das Substrat gerichtet zu werden, erzeugt wird, und indem man gleichzeitig an das Substrat eine elektrische Gleichspannung oder eine elektrische Wechselspannung mit einer Frequenz im Radiofrequenzbereich anlegt.

13. Verfahren nach einem der Ansprüche 1 bis 11, dadurch gekennzeichnet, daß man die Ätzung mittels eines gasförmigen Plasmas durchführt, das durch Höchstfrequenzwellen erzeugt wird, indem auf das Substrat mittels einer Zelle aus einem für die Höchstfrequenzwellen transparentem Material ein gasförmiges Plasma beschränkt, das durch eine transversale, einmodige Kopplung zwischen einem Wellenleiter, der von Höchstfrequenzwellen durchlaufen wird, und der Zelle, in der wenigstens ein Teil der gasförmigen Umgebung senkrecht zu den Höchstfrequenzwellen zirkuliert, um auf das Substrat gerichtet zu werden, erzeugt wird.

## Claims

1. Process for etching a substrate with the aid of a gas plasma produced either by ultra-high frequency waves, or by radio-frequency waves and ultra-high frequency waves, characterized in that the gaseous medium used for forming the plasma comprises at least one non-carbon-containing fluorinating gas, at least one rare gas and at least one non-carbon-containing oxidizing gas.

2. Process according to claim 1, characterized in that the gaseous medium also comprises at least one other gas chosen from among nitrogen and chlorine-containing gases.

3. Process according to any one of the claims 1 and 2, characterized in that the non-carbon-containing fluorinating gas is sulphur hexafluoride $SF_6$.

4. Process according to any one of the claims 1 to 3, characterized in that the rare gas is argon or a mixture of argon and helium.

5. Process according to any one of the claims 1 to 4, characterized in that the oxidizing gas is oxygen.

6. Process according to claim 1, characterized in that the gaseous medium is constituted by sulphur hexafluoride, argon and oxygen.

7. Process according to claim 6, characterized in that the respective flow rates of sulphur hexafluoride, argon and oxygen are
– 4 to 500 cm³ standard/min for $SF_6$,
– 4 to 500 cm³standard/min for Ar and

– 2 to 500 cm³ standard/min for $O_2$.

8. Process according to claim 1, characterized in that the gaseous medium is constituted by sulphur hexafluoride, argon, oxygen and nitrogen.

9. Process according to claim 8, characterized in that the respective flow rates of sulphur hexafluoride, argon, oxygen and nitrogen are
– 4 to 500 cm³ standard/min for $SF_6$,
– 4 to 500 cm³ standard/min for Ar,
– 1 to 300 cm³ standard/min for $O_2$ and
– 1 to 300 cm³ standard/min for $N_2$.

10. Process according to any one of the claims 1 to 9, characterized in that the substrate is of silicon.

11. Process according to any one of the claims 1 to 10, characterized in that etching is performed under a pressure of 0.1 to 300 Pa.

12. Process according to any one of the claims 1 to 11, characterized in that etching is carried out by means of a gas plasma produced by ultra-high frequency waves and radio-frequency waves by confining on the substrate by a cell made from a material transparent to ultra-high frequency waves a gas plasma produced by transverse monomode coupling between a waveguide traversed by ultra-high frequency waves and the cell in which at least part of the gaseous etching medium circulates perpendicular to the ultra-high frequency waves to be directed onto the substrate and by simultaneously applying to the substrate a d.c. or a.c. voltage having a frequency in the radio-frequency range.

13. Process according to any one of the claims 1 to 11, characterized in that etching is carried out by means of a gas plasma produced by ultra-high frequency waves by confining on the substrate using a cell made from a material transparent to ultra-high frequency waves a gas plasma produced by transverse monomode coupling between a waveguide traversed by ultra-high frequency waves and the cell in which at least part of the gaseous etching medium circulates perpendicular to the ultra-high frequency waves to be directed onto the substrate.

EP 0 359 777 B1